# EUROPÄISCHE PATENTANMELDUNG

(11) **EP 0 980 200 A2**
(43) Veröffentlichungstag der Anmeldung: **16.02.2000**
(21) Anmeldenummer: 99114148.2
(22) Anmeldetag: 20.07.1999
(51) Int. Cl.: H05K 5/00, H04M 1/02

(54) **Moduleinheit für eine Türanlage, insbesondere Türsprechanlage**

(30) Priorität: 12.08.1998 DE 19836420
(71) Anmelder: Ritto - Werk Loh GmbH & Co. KG, 35708 Haiger (DE)
(72) Erfinder: Achenbach, Heinz, 35236 Breidenbach (DE)
(74) Vertreter: Fleck, Hermann-Josef, Dr.-Ing.

(57) **Zusammenfassung**

Die Erfindung betrifft eine Moduleinheit für eine Türanlage, insbesondere Türsprechanlage, die zeilen- und/oder spaltenweise in den Aufnahmeraum eines Gehäuses einsetzbar und darin festlegbar ist. Der Einbau und die Verdrahtung einer Türanlage mit mehreren Moduleinheiten wird dadurch vereinfacht und erleichtert, dass sie an allen vier Außenseitenwänden mit Verbindungselementen versehen ist, die eine mechanische und/oder elektrische Verbindung zu benachbarten Moduleinheiten zu einer Rastereinheit ermöglichen, die als Ganzes in den Aufnahmeraum des Gehäuses einsetzbar ist.

## Beschreibung

Die Erfindung betrifft eine Moduleinheit für eine Türanlage, insbesondere Türsprechanlage, die zeilen- und/oder spaltenweise in den Aufnahmeraum eines Gehäuses einsetzbar und darin festlegbar ist.

Türanlagen, insbesondere Türsprechanlagen, mit rasterartiger Anordnung der mit einheitlicher Außenkontur versehenen Moduleinheiten sind in verschiedenen Ausgestaltungen bekannt, wie z.B. die DE 31 08 056 C2, die DE 84 10 385 U1, die DE 29 21 485 A1 und die DE 40 19 837 C2 zeigen. Dabei werden die Moduleinheiten jeweils einzeln in das Gehäuse eingesetzt und darin gehalten. Außerdem ist für die elektrische Verdrahtung der Moduleinheiten und für die Verbindung derselben mit dem Anschlußkabel für die Türanlage ein erheblicher zusätzlicher Teile- und Montageaufwand erforderlich.

Es ist Aufgabe der Erfindung, eine Moduleinheit der eingangs erwähnten Art zu schaffen, die bezüglich des Einbaus in das Gehäuse und des elektrischen Anschlusses im Teile- und Montageaufwand wesentlich vereinfacht ist.

Diese Aufgabe wird nach der Erfindung dadurch gelöst, daß die Moduleinheit an allen vier Außenseitenwänden mit Verbindungselementen versehen ist, die eine mechanische und/oder elektrische Verbindung zu benachbarten Moduleinheiten zu einer Rastereinheit ermöglichen, die als Ganzes in den Aufnahmeraum des Gehäuses einsetzbar ist.

Mit den Verbindungselementen der Moduleinheiten können die Moduleinheiten zu einer vormontierten und vorverdrahteten Rastereinheit zusammengesetzt werden, die als Ganzes in das Gehäuse eingesetzt und darin festgelegt werden kann. Diese Rastereinheit braucht dann nur noch elektrisch mit dem Anschlußkabel verbunden zu werden.

Um eine Anreihung der Moduleinheit in Zeilen- und Spaltenrichtung zu erhalten, ist die Anordnung und Verteilung der Verbindungselemente so gewählt, daß die Verbindungselemente an einander gegenüberliegenden Außenseitenwänden jeweils komplementär ausgebildet sind.

Für einen ausreichend festen Halt der Moduleinheiten in der Rastereinheit gibt es zahlreiche Gestaltungsmöglichkeiten für mechanische Verbindungselemente. So kann nach einer Ausgestaltung vorgesehen sein, dass die Verbindungselemente für die mechanische Verbindung als Steckansatz und Steckaufnahme ausgebildet sind, die senkrecht zu den Außenwänden der Moduleinheiten ineinander steckbar sind. Es kann jedoch der mechanisch feste Halt der Moduleinheiten in der Rastereinheit auch dadurch erreicht werden, dass die Verbindungselemente für die mechanische Verbindung als Feder- und Nutelemente ausgebildet sind, die senkrecht zur Frontseite der Moduleinheiten ineinander steckbar sind oder dass die Verbindungselemente für die mechanische Verbindung als Rastfedern und Rastaufnahmen ausgebildet sind, die senkrecht zu den Außenseitenwänden ineinander steckbar und senkrecht zur Frontseite der Moduleinheiten miteinander verrastbar sind. Ein zusätzlicher Teileaufwand für die mechanischen Verbindungselemente läßt sich dadurch vermeiden, dass die Verbindungselemente für die mechanische Verbindung an den Außenseitenwänden einstückig angeformt oder in diese eingeformt sind.

Für die elektrische Verbindung der Moduleinheiten ist nach einer Ausgestaltung vorgesehen, dass die Verbindungselemente für die elektrische Verbindung als Steckerleiste und Steckbuchse ausgebildet sind, die senkrecht zu den Außenseitenwänden der Moduleinheiten miteinander verbindbar sind. Dabei sind die Steckbuchsen bündig in die Außenseitenwände eingebaut.

Zur Festlegung der Rastereinheit im Gehäuse ist nach einer weiteren Ausgestaltung vorgesehen, dass die Steckbuchsen bündig in die Außenseitenwände eingebaut sind. Dabei können diese Haltelemente der Moduleinheit und die komplementären Halteelemente in bekannter Weise ausgebildet sein, wie z.B. die DE 40 19 837 C2 zeigt, wobei die Verbindungsrichtung parallel oder senkrecht zur Frontseite des Gehäuses vorgenommen werden kann und eine gemeinsame Frontplatte die Rastereinheit zusätzlich im Gehäuse festhalten und abdecken kann.

Die Erfindung wird anhand eines in der Zeichnung dargestellten Ausführungsbeispiels näher erläutert. Es zeigen:
Fig. 1 in perspektivischer Ansicht eine Moduleinheit und
Fig. 2 zwei Moduleinheiten in Montagestellung.

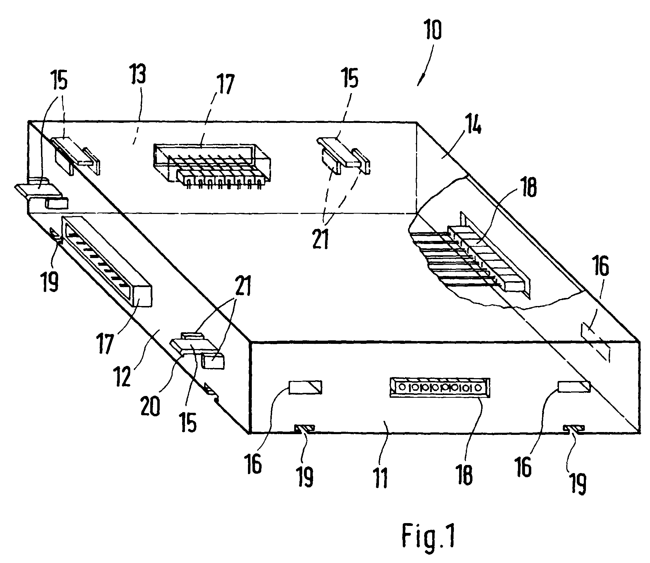

Wie Fig. 1 zeigt, bilden die Moduleinheiten 10 mit ihren Außenseitenwänden 11 bis 14 im wesentlichen eine quadratische Außenkontur, so daß sie an allen vier Außenseitenwänden 11 bis 14 aneinander reihbar sind. So lassen sich Rastereinheiten aus Zeilen und/oder Spalten von Moduleinheiten 10 bilden.

Damit die Moduleinheiten 10 vor dem Einsetzen in ein Gehäuse oder einen Aufnahmerahmen, der selbst wieder mit dem Gehäuse verbunden oder verbindbar ist, zu einer festen Rastereinheit zusammengesetzt werden können, sind alle Außenseitenwände 11 bis 14 mit mechanischen und/oder elektrischen Verbindungselementen versehen.

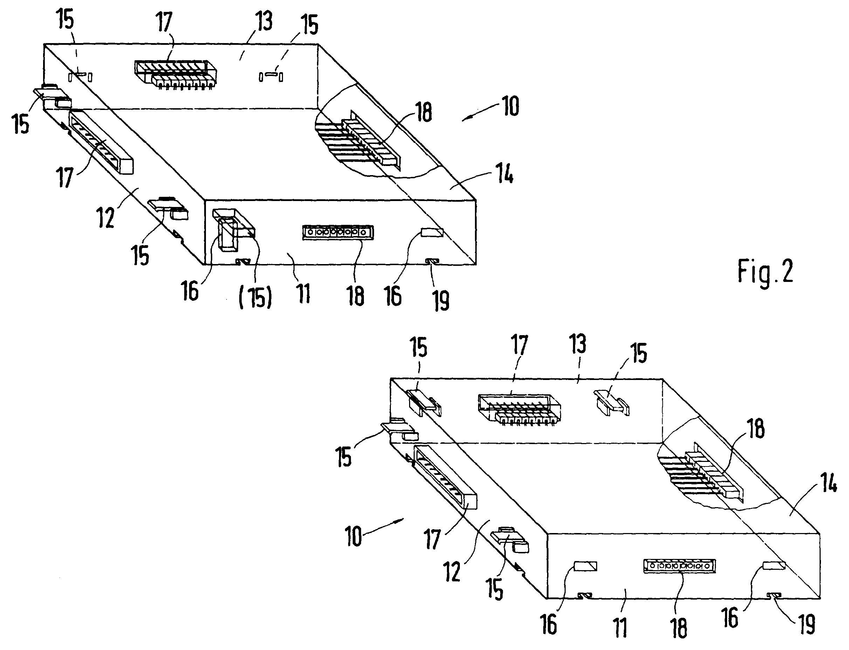

Damit die Moduleinheiten 10 in gleicher vertikaler Ausrichtung miteinander verbunden werden können, sind die Verbindungselemente 15 und 16 bzw. 17 und 18 an einander gegenüberliegenden Außenseitenwänden 11 und 13 bzw. 12 und 14 komplementär zueinander gestaltet. So können die mechanischen Verbindungselemente 15 und 16 als Rastfeder und Rastaufnahme ausgebildet sein, wobei die auslenkbare Rastfeder in der zur Frontseite der Moduleinheit 10 parallelen Rastrichtung in eine Rastaufnahme einer benachbarten Moduleinheit 10 eingerastet wird, wie der Fig. 1 zu entnehmen ist. Die als Rastfedern ausgebildeten mechanischen Verbindungselemente 15 der Außenseitenwände 13 der unteren Moduleinheit 10 der Fig. 2 werden dabei in die als Rastaufnahmen ausgebildeten komplementären Verbindungselemente 16 in der Außenseitenwand 11 der oberen Modulenheit 10 der Fig. 2 eingeführt und eingerastet. Die elektrischen Verbindungselemente 17 und 18 sind als Steckerleiste und Steckbuchse ausgebildet, so daß die aneinander gereihten Moduleinheiten 10 in der Rastereinheit auch elektrisch parallel geschaltet werden. Dabei verbessern die elektrischen Verbindungselemente 17 und 18 den mechanischen Halt der Rastereinheit. Die Verteilung der mechanischen und elektrischen Verbindungselemente 15, 16 und 17, 18 ist an den einander gegenüberliegenden Außenseitenwände 11 und 13 bzw. 12 und 14 stets komplementär, um die allseitige mechanische und elektrische Aneinanderreihung der Moduleinheiten 10 zu gewährleisten.

Die Steckbuchsen als elektrisches Verbindungselement 18 sind in den Außenseitenwänden 11 und 14 bündig eingebaut, während die als Steckerleisten ausgebildeten elektrischen Verbindungselemente 17 an den Außenseitenwänden 12 und 13 wie die mechanischen, als Rastfedern ausgebildeten Verbindungselemente 15 vorstehen und so ineinander steckbar sind, dass die Moduleinheiten 10 in der Rastereinheit satt aneinander liegen.

Ist nur eine mechanische Verbindung zwischen benachbarten Moduleinheiten 10 erforderlich, dann können die Verbindungselemente auch so gestaltet sein, dass sie senkrecht zur Frontseite der Moduleinheiten miteinander verbindbar sind. Dabei können die Verbindungselemente auch eine Nut-Feder-Verbindung oder eine feste Steckverbindung herstellen. Es gibt dazu viele konstruktive Lösungen, die alle für die feste Verbindung der Moduleinheiten 10 in der Rastereinheit verwendet werden können.

Die elektrische Parallelschaltung der Moduleinheiten 10 ist besonders dann von Vorteil, wenn die Türanlage über eine Busleitung mit allen Wohnungsstellen verbunden ist und der Verbindungsaufbau und -abbau sowie die Sprechverbindung über diese Busleitung vorgenommen wird.

Die Rastereinheit wird als Ganzes in ein boxartiges Gehäuse eingesetzt und kann mit einer abdeckenden Frontplatte darin gehalten werden. Dabei können zusätzliche Halteelemente im Gehäuse und komplementäre Halteelemente an den Außenseitenwänden 11 bis 14 der Moduleinheiten 10 die Positionierung und die Festlegung der Rastereinheit im Gehäuse verbessern. Am Gehäuse kann auch eine Seitenwand abnehmbar angebracht sein. Bei abgenommener Seitenwand kann die Rastereinheit über diese offene Seite des Gehäuses in das Gehäuse parallel zu dessen Frontseite eingeschoben werden. Dabei sind am Boden und/oder den Außenseitenwänden der Moduleinheiten 10 Halteelemente und komplementäre Halteelemente 19 an- oder eingeformt, um die Rastereinheit im Gehäuse festzulegen. Nach dem Einschieben der Rastereinheit in das Gehäuse wird die Seitenwand mit dem Gehäuse verbunden und die Rastereinheit eindeutig und unlösbar darin festgehalten. Die Rastereinheit braucht nur noch mit dem Anschlußkabel verbunden zu werden.

## Patentansprüche

1. Moduleinheit für eine Türanlage, insbesondere Türsprechanlage, die zeilen- und/oder spaltenweise in den Aufnahmeraum eines Gehäuses einsetzbar und darin festlegbar ist,
dadurch gekennzeichnet,
dass sie an allen vier Außenseitenwänden (11 bis 14) mit Verbindungselementen (15, 16, 17, 18) versehen ist, die eine mechanische und/oder elektrische Verbindung zu benachbarten Moduleinheiten (10) zu einer Rastereinheit ermöglichen, die als Ganzes in den Aufnahmeraum des Gehäuses einsetzbar ist.

2. Moduleinheit nach Anspruch 1,
dadurch gekennzeichnet,
dass die Verbindungselemente (15 und 16 bzw. 17 und 18) an einander gegenüberliegenden Außenseitenwänden (11 und 13 bzw. 12 und 14) jeweils komplementär ausgebildet sind.

3. Moduleinheit nach Anspruch 1 oder 2,
dadurch gekennzeichnet,
dass die Verbindungselemente (15 und 16) für die mechanische Verbindung als Steckansatz und Steckaufnahme ausgebildet sind, die senkrecht zu den Außenseitenwänden (11 bis 15) der Moduleinheiten (10) ineinander steckbar sind.

4. Moduleinheit nach Anspruch 1 oder 2,
dadurch gekennzeichnet,
dass die Verbindungselemente (15 und 16) für die mechanische Verbindung als Feder- und Nutelemente ausgebildet sind, die senkrecht zur Frontseite der Moduleinheiten (10) ineinander steckbar sind.

5. Moduleinheit nach Anspruch 1 oder 2,
dadurch gekennzeichnet,
dass die Verbindungselemente (15 und 16) für die mechanische Verbindung als Rastfedern und Rastaufnahmen ausgebildet sind, die senkrecht zu den Außenseitenwänden (11 bis 14) ineinander steckbar und senkrecht zur Frontseite der Moduleinheiten (10) ineinander verrastbar sind.

6. Moduleinheit nach einem der Ansprüche 1 bis 5,
dadurch gekennzeichnet,
dass die Verbindungselemente (15 und 16) für die mechanische Verbindung an den Außenseitenwänden (11 bis 14) einstückig angeformt oder in diese eingeformt sind.

7. Moduleinheit nach einem der Ansprüche 1 bis 6,
dadurch gekennzeichnet,
dass die Verbindungselemente (17 und 18) für die elektrische Verbindung als Steckerleiste und Steckbuchse ausgebildet sind, die senkrecht zu den Außenseitenwänden (11 bis 14) der Moduleinheiten (10) miteinander verbindbar sind.

8. Moduleinheit nach Anspruch 7,
dadurch gekennzeichnet,
dass die Steckbuchsen bündig in die Außenseitenwände (11, 14) eingebaut sind.

9. Moduleinheit nach einem der Ansprüche 1 bis 8,
dadurch gekennzeichnet,
dass die Außenseitenwände (11 bis 14) und/oder der Boden des Modulgehäuses mit zusätzlichen Haltelementen (19) versehen ist (sind), die mit komplementären Halteelementen im Gehäuse zur Festlegung der Rastereinheit im Gehäuse dienen.
